# EUROPÄISCHE PATENTANMELDUNG

(11) **EP 0 940 861 A2**
(43) Veröffentlichungstag der Anmeldung: **08.09.1999**
(21) Anmeldenummer: 99103171.7
(22) Anmeldetag: 18.02.1999
(51) Int. Cl.: H01L 33/00

(54) **Leuchtdiode**

(30) Priorität: 05.03.1998 DE 29803840 U
(71) Anmelder: E.G.O. Control Systems GmbH & Co. KG, 72336 Balingen-Frommern (DE)
(72) Erfinder: Gänsler, Walter, 72336 Balingen-Ostdorf (DE)
(74) Vertreter: Otte, Peter, Dipl.-Ing.

(57) **Zusammenfassung**

Eine Leuchtdiode umfassend einen Anschlußpins (30) einbettenden Basiskörper (10) und einen daran anschließenden Leuchtkörper (20), wobei der Leuchtkörper (20) einen kleineren Durchmesser als der Basiskörper (10) aufweist, ist dadurch gekennzeichnet, daß die axiale Länge des Basiskörpers (l_{G}) größer ist als die axiale Länge des Leuchtkörpers (l_{L}).

## Beschreibung

Die Erfindung betrifft eine Leuchtdiode umfassend einen Anschlußpins einbettenden Basiskörper und einen daran anschließenden Leuchtkörper, wobei der Leuchtkörper einen kleineren Durchmesser als der Basiskörper aufweist.

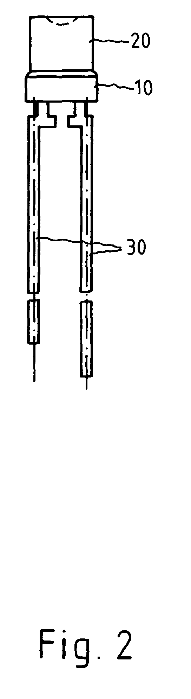

Derartige Leuchtdioden werden in vielfältiger Weise zur Bestückung auf Leiterplatten, insbesondere zur automatischen Bestückung auf Leiterplatten, eingesetzt. Eine aus dem Stand der Technik bekannte Leuchtdiode ist in Fig. 2 vergrößert dargestellt. Eine solche Leuchtdiode weist einen Basiskörper 10 und einen sich daran anschließenden Leuchtkörper 20 auf. In den Basiskörper 10 sind Anschlußpins 30 eingebettet, die, wie in Fig. 2 dargestellt ist, abgewinkelt sein können.

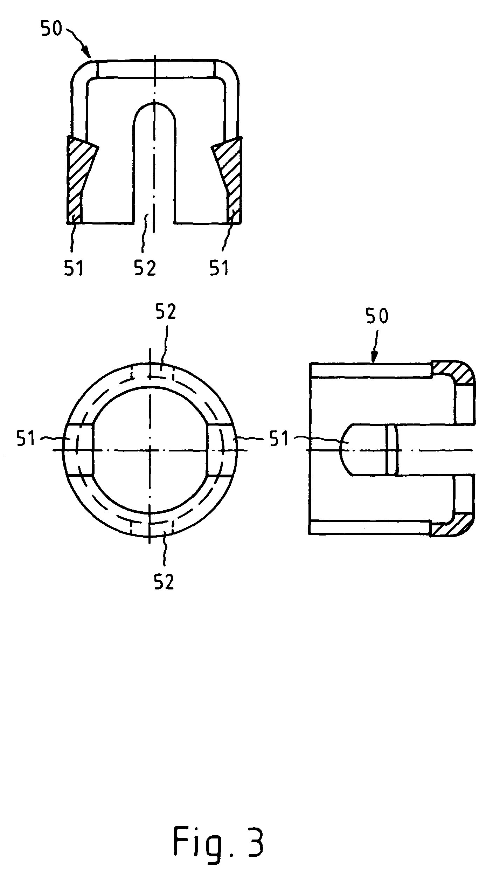

Um die Anordnung des Leuchtkörpers 20 über einer (nicht dargestellten) Leiterplatte in einer gewünschten Höhe zu ermöglichen, wird eine derartige Leuchtdiode mit Hilfe eines sogenannten Distanzrings durch Lötverbindungen auf der Leiterplatte befestigt. Verschiedene Ansichten eines derartigen, aus dem Stand der Technik bekannten Distanzrings 50 sind in Fig. 3 vergrößert dargestellt.

Der Distanzring 50 weist seitliche Klemmbacken 51 auf, die sich an der Unterseite des Basiskörpers 10 der Leuchtdiode festhaken, nachdem der Distanzring 50 über den Basiskörper 10 der Leuchtdiode geschoben wurde. Um eine einfache Montage zu ermöglichen, sind in dem Distanzring 50 Federöffnungen 52 vorgesehen, die, wie in Fig. 3 dargestellt ist, vorteilhafterweise jeweils um 90° zu den Klemmbacken 51 versetzt angeordnet sind. Durch diese Federöffnungen 52 federn die Klemmbacken 51 beim Überschieben des Distanzrings 50 über den Basiskörper 10 ein wenig auseinander, bis sich die abgeschrägten Flächen der Klemmbacken 51 an der Unterseite des Basiskörpers 10 festhaken und somit den gewünschten Abstand zwischen Leiterplatte und Leuchtdiode realisieren.

Nachdem der Distanzring 50 an dem Basiskörper 10 der Leuchtdiode montiert ist, erfolgt die Bestückung auf einer Leiterplatte und die elektrische Kontaktierung durch Lötverbindungen. Der Distanzring 50 stellt dabei sicher, daß der Leuchtkörper 20 in einem vorgegebenen Abstand über der Trägerplatte angeordnet ist.

Eine derartige Montage der Leuchtdiode ist nicht nur verhältnismäßig umständlich, da vor jeder Montage der Leuchtdiode immer erst der Distanzring 50 an der Leuchtdiode angeordnet werden muß, darüber hinaus besteht auch die Möglichkeit, daß aufgrund mechanischer oder thermischer Beanspruchung der Anschlußpins 30 bei der Montage der Leuchtdiode Risse im Basiskörper 10 entstehen können.

Ein Problem bei der Montage der Leuchtdiode über einen derartigen Distanzring 50 besteht darüber hinaus nicht nur darin, daß ein solcher Distanzring beim Transport oder der Verarbeitung leicht verloren gehen kann, sondern daß er auch aufwendig zu montieren ist. Dabei besteht insbesondere die Gefahr, daß er falsch montiert wird.

Der Erfindung liegt daher die Aufgabe zugrunde, eine gattungsgemäße Leuchtdiode derart weiterzubilden, daß sie nicht nur auf einfache Weise zu montieren ist, wobei ein exakter Abstand des Leuchtkörpers über der Trägerplatte eingehalten werden kann, sondern daß auch obenerwähnte Risse in dem Basiskörper weitestgehend vermieden werden und die Anschlußpins einen wesentlich größeren Widerstand gegenüber einer Verbiegung bei einer Erwärmung, die beim Löten auftritt, als herkömmliche Leuchtdioden aufweisen.

Diese Aufgabe wird bei einer Leuchtdiode der eingangs beschriebenen Art erfindungsgemäß dadurch gelöst, daß die axiale Länge des Basiskörpers größer ist als die axiale Länge des Leuchtkörpers. Vorzugsweise entspricht die Länge des Basiskörpers zwischen dem 1,4-fachen und dem 4-fachen der Länge des Leuchtkörpers.

Vorteilhafterweise ist die Länge des Basiskörpers auf eine konkrete Bestückungssituation auf einer Leiterplatte anpaßbar.

Bisher wurden noch keine näheren Angaben über das Durchmesserverhältnis zwischen Leuchtkörper und Basiskörper gemacht. Der Durchmesser des Basiskörpers variiert vorteilhafterweise zwischen dem 1,4-fachen und dem 3-fachen des Durchmessers des Leuchtkörpers.

Durch das Längenverhältnis sowie das Durchmesserverhältnis von Basiskörper zu Leuchtkörper wird auf sehr vorteilhafte Weise nicht nur eine besonders sichere Einbettung der Anschlußpins der Leuchtdiode ermöglicht und dadurch weitestgehend vermieden, daß bei der Montage aufgrund mechanischer oder thermischer Beanspruchung der Anschlußpins Risse im Basiskörper entstehen. Es wird darüber hinaus auch der Abstand des Leuchtkörpers über der Leiterplatte durch einen einzigen Montageschritt festgelegt, ohne daß wie beim Stand der Technik zusätzliche Distanzringe oder dergleichen Hilfsmittel, welche einen definierten Abstand des Leuchkörpers über der Leiterplatte ermöglichen, notwendig sind.

Um sicherzustellen, daß der Basiskörper auf der Leiterplatte im montierten Zustand gleichmäßig aufliegt, weist er auf seiner den Anschlußpins zugewandten Seite eine plane oder leicht konkave Grundfläche auf. Die Grundfläche ist dabei derart konkav, daß eine Vertiefung in Richtung des Leuchtkörpers vorgesehen ist, so daß in diesem Falle der Basiskörper ringförmig auf der Leiterplatte aufliegt.

Die Anschlußpins bestehen vorteilhafterweise aus Kupfer.

Hierdurch wird sichergestellt, daß die Belastung der Anschlußpins beim Bestückungsvorgang verringert wird. Dabei wird insbesondere vermieden, daß sich die beim Befestigen durch Clinch-Verfahren auftretenden Spannungen während des Wellenlötens bis zum Bonddraht des Chips fortsetzen und dadurch zu Unterbrechungen oder zu einer Vorschädigung führen können. Derartige Spannungen entstehen beispielsweise bei den obenbeschriebenen, aus dem Stand der Technik bekannten Leuchtdioden, so daß diese nicht oder nur bedingt für eine automatische Bestückung mit der üblichen Clinch-Methode geeignet sind.

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: ein Ausführungsbeispiel einer erfindungsgemäßen Leuchtdiode in vergrößerter Darstellung;
- Fig. 2: ein Ausführungsbeispiel einer aus dem Stand der Technik bekannten Leuchtdiode in vergrößerter Darstellung und
- Fig. 3: verschiedene, teilweise geschnittene Seitenansichten eines Distanzrings, für die Montage der in Fig. 2 dargestellten Leuchtdiode in vergrößerter Darstellung.

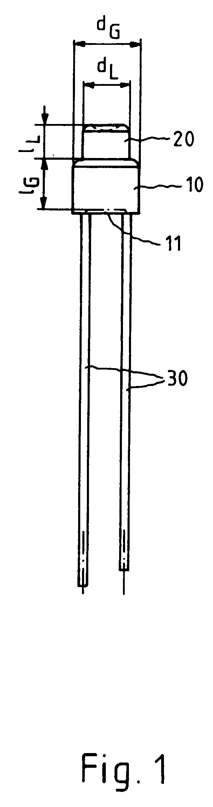

Ein Ausführungsbeispiel einer Leuchtdiode, dargestellt in Fig. 1, umfaßt einen Basiskörper 10, an den sich einstückig ein Leuchtkörper 20 anschließt. In dem Basiskörper 10 sind aus Kupfer bestehende Anschlußpins 30 zur Montage der Leuchtdiode auf einer Trägerplatte, insbesondere auch zur automatischen Montage, eingebettet.

Um eine sichere Einbettung der Anschlußpins 30 zu gewährleisten und um insbesondere zu verhindern, daß bei einer mechanischen oder thermischen Beanspruchung der Anschlußpins bei der Montage der Leuchtdiode auf der Leiterplatte Risse im Basiskörper 10 entstehen, ist vorteilhafterweise vorgesehen, daß das Verhältsnis des Durchmessers des Leuchtkörpers d_{L} zu dem Durchmesser des Basiskörpers d_{G} 1:1,4 ist.

Das Verhältnis der Länge des Basiskörpers 10 l_{G} zu der Länge des Leuchtkörpers 20 l_{L} ist bei dem gezeigten Ausführungsbeispiel 1,56:1.

Vorteilhafterweise kann das Verhältnis der Durchmesser von Leuchtkörper zu Basiskörper d_{L}:d_{G} zwischen 1:1,4 und 1:3 variieren.

Das Verhältnis der Länge des Basiskörpers 10 zur Länge des Leuchtkörpers 20 l_{G}:l_{L} kann zwischen 1,4:1 und 4:1 variieren.

Der Basiskörper 10 weist auf seiner den Anschlußpins 30 zugewandten Seite 11 eine plane oder leicht konkave Grundfläche 11 auf. Die Grundfläche 11 ist dabei in Richtung des Leuchtkörpers 20 konkav. Hierdurch liegt der Basiskörper 10 im montierten Zustand der Leuchtdiode eben oder ringartig auf der Leiterplatte auf.

Es versteht sich, daß die Länge l_{G} des Basiskörpers 10 auf verschiedene Einbausituationen auf einer Leiterplatte anpaßbar ist, sie bewegt sich dabei in den oben angegebenen Grenzen.

## Patentansprüche

1. Leuchtdiode umfassend einen Anschlußpins (30) einbettenden Basiskörper (10) und einen daran anschließenden Leuchtkörper (20), wobei der Leuchtkörper (20) einen kleineren Durchmesser als der Basiskörper (10) aufweist, dadurch gekennzeichnet, daß die axiale Länge des Basiskörpers (l_{G}) größer ist als die axiale Länge des Leuchtkörpers (l_{L}).

2. Leuchtdiode nach Anspruch 1, dadurch gekennzeichnet, daß das Längenverhältnis von Basiskörper (10) zu Leuchtkörper (20) l_{G}:l_{L} zwischen 1,4:1 und 4:1 variiert.

3. Leuchtdiode nach Anspruch 1 oder 2, dadurch gekennzeichnet, daß die Länge des Basiskörpers (10) auf eine konkrete Bestükungssituation auf einer Leiterplatte anpaßbar ist.

4. Leuchtdiode nach einem der Ansprüche 1 bis 3, dadurch gekennzeichnet, daß das Verhältnis des Durchmessers des Leuchtkörpers (d_{L}) zu dem Durch-messer des Basiskörpers (d_{G}) variiert zwischen 1:1,4 und 1:3.

5. Leuchtdiode nach einem der voranstehenden Ansprüche, dadurch gekennzeichnet, daß die Anschlußpins (30) aus Kupfer bestehen.
